# NEUE EUROPÄISCHE PATENTSCHRIFT

(11) **EP 2 570 881 B2**
(45) Veröffentlichungstag und Bekanntmachung des Hinweises auf die Entscheidung über den Einspruch: **19.02.2020**
(45) Hinweis auf die Patenterteilung: 01.03.2017
(21) Anmeldenummer: 12183313.1
(22) Anmeldetag: 06.09.2012
(51) Int. Cl.: G05D 23/02, G05D 23/19, F24D 19/10, H01L 35/00

(54) **Temperaturregelvorrichtung, insbesondere Thermostatvorrichtung**
Temperature control device, particularly a thermostatic device
Dispositif de régulation de température, en particulier un dispositif thermostatique

(30) Priorität: 13.09.2011 DE 102011053563
(43) Veröffentlichungstag der Anmeldung: 20.03.2013
(73) Patentinhaber: Kieback & Peter GmbH & Co. KG, 12347 Berlin (DE)
(72) Erfinder: Maass, Jürgen, 12349 Berlin (DE); Korsus, René, 12309 Berlin (DE); Handke, Sebastian, 12345 Berlin (DE)
(74) Vertreter: Naeven, Ralf

(56) Entgegenhaltungen:
- EP-A1- 1 729 195
- WO-A1-2004/082099
- GB-A- 2 216 293
- GB-A- 2 278 934
- US-A- 4 618 091

## Beschreibung

Die Erfindung betrifft eine Temperaturregelvorrichtung gemäß dem Oberbegriff des Anspruchs 1.

Derartige Temperaturregelvorrichtungen können vielfältig eingesetzt werden, wenn mit einem fluiden Wärme- oder Kältemittel Temperaturen gesteuert oder geregelt werden sollen. Die vorliegende Erfindung wird beispielhaft anhand einer Thermostatvorrichtung für eine Heizungsanlage dargestellt, gilt aber in entsprechender Weise für Kühlungsanlagen.

Temperaturregelvorrichtungen, bei denen mittels eines Motors eine Ventilstellung beeinflusst wird, bedürfen einer Energieversorgungseinrichtung für die Motoreinheit. Um einen energieautarken Betrieb zu ermöglichen, insbesondere unter Vermeidung der Zuführung von Stromleitungen, werden vermehrt Energieharvester eingesetzt, die aus den Umgebungsbedingungen, z. B. aus Lichteinstrahlung oder gegebenen Temperaturdifferenzen, Energie erzeugen.

Eine Temperaturregelvorrichtung der eingangs genannten Art ist aus der DE 10 2005 025 501 A1 bekannt. Dort wird als Energieharvester ein thermoelektrischer Generator, im Folgenden kurz Thermogenerator genannt, eingesetzt, der nach dem Seebeck-Effekt arbeitet. In einem Thermogenerator werden zwei geeignete unterschiedliche Metalle oder Halbleiter miteinander kontaktiert. Wird ein Thermogenerator in geeigneter Weise mit Bereichen unterschiedlicher Temperatur in Kontakt gebracht, wird eine Spannung erzeugt, die nutzbar ist. Die DE 10 2005 025 501 C5 offenbart es, den Thermogenerator zwischen einem wärmeleitenden Träger als Wärmequelle und einem Kühlkörper als Wärmesenke anzuordnen.

Unter dem Begriff Wärmequelle wird im Folgenden eine dem Thermogenerator unmittelbar über Wärmeleitung Wärme zuführende massive Einheit verstanden, welches nicht selbst Wärme erzeugt sondern lediglich die anderweitig erzeugte Wärme zum Thermoelement hin weiterleitet. Die Wärmesenke meint vorliegend eine dem Thermogenerator unmittelbar über Wärmeleitung Wärme entziehende massive Einheit.

Gemäß dem vorgenannten Stand der Technik steht der wärmeleitende Träger als Wärmequelle in wärmeleitender Verbindung mit dem Heizungszulauf, während die Wärmesenke durch die Raumluft gekühlt wird. Hierzu wird vorgesehen, umgebende Gehäuseteile oder Umhüllungen mit zumindest einer Öffnung zu versehen, damit ein entsprechender Luftaustausch stattfinden kann. Es ist des Weiteren offenbart, einen Spannungsverstärker für den Thermogenerator vorzusehen, weil originär vom Thermogenerator erzeugte Spannungen oftmals für die angestrebten Zwecke zu gering sind. Eine Erhöhung der originär am Thermogenerator erzeugten Spannung könnte durch eine Erhöhung der am Thermogenerator anliegenden Temperaturdifferenz erreicht werden.

Aus der EP 0 717 332 A1 ist eine elektrische Antriebssteuerung für Heizungsventile mit einem thermoelektrischen Generator bekannt. Auch hier sind die Wärmequelle mit dem einfließenden Heizungswasser und die Wärmesenke entweder mit dem ausfließenden kälteren Wasser oder der Umgebungstemperatur in wärmeleitendem Kontakt. Es ist allerdings nicht offenbart, wie die Wärmesenke im Falle der Nutzung der Umgebungstemperatur tatsächlich gestaltet ist.

Aus der US 4,618,091 A ist eine flüssigkeitsdurchflossene Temperaturregelvorrichtung mit einem Ventil und einer elektronischen Steuereinheit für das Ventil bekannt. Ein Thermogenerator dient zur Stromversorgung der Steuereinheit und des Ventilmotors. Der Thermogenerator ist auf einer ersten Seite im Wärmekontakt mit dem zu regelnden Flüssigkeitsstrom, während eine zweite Seite einer anderen Temperatur ausgesetzt ist. In einer ersten in der US 4,618,091 A offenbarten Ausführungsform ist der Thermogenerator als Trennwand zwischen einer Kammer für Warmwasser und einer Kammer für Kaltwasser angeordnet, so dass die zweite Seite des Thermogenerators mit dem Kaltwasser in Kontakt steht. Des Weiteren ist in der US 4,618,091 A ein Thermogenerator offenbart, der eine Durchflussröhre für Warmwasser und auf einer Außenwand eine Vielzahl von in Umfangsrichtung verlaufende Kühlfinnen aufweist. Das Thermopaar ist als Hülse aufgebaut, die zum einen die Durchflussröhre umgibt, welche die Wärmequelle bildet, und zum anderen die die Wärmsenke bildende Außenwand mit den Kühlfinnen aufweist. Die Anordnung relativ zu einem Ventil, dessen Motor oder Steuerung mit der vom Thermogenerator erzeugten Energie versorgt wird, ist nicht aufgezeigt.

Aus der GB 2 216 293 A ist eine Ventilsteuervorrichtung für Radiatoren bekannt, welche zur Versorgung eines Ventilmotors eine wieder aufladbare Energiequelle und einen Thermogenerator aufweist, welcher an der Energiequelle elektrisch angeschlossen ist. Der Thermogenerator ist mit einer Seite am Radiator angeschlossen, während die andere Seite zur umgebenden Luft offen ist.

Aus der DE 10 2008 031 266 A1 ist ein Thermogenerator bekannt, der sich dadurch kennzeichnet, dass die beiden Generatoroberflächen mit unterschiedlichen Mitteln derart versehen sind, dass sich bei ändernden Umgebungstemperaturen die Oberflächentemperatur der ersten Generatoroberfläche sich möglichst schnell und die Oberflächentemperatur der zweiten Generatoroberfläche sich möglichst langsam an eine neue Umgebungstemperatur anpasst. Bei raschen Änderungen der Umgebungstemperatur, wie sie z.B. bei Höhenänderungen während eines Fluges vorkommen, führt die unterschiedlich schnelle Anpassung der Oberflächentemperaturen zu Temperaturdifferenzen, die zur Energiegewinnung ausgenutzt werden können. Ein Zusammenhang zu Temperaturregelvorrichtungen ist nicht offenbart.

Es ist nun Aufgabe der vorliegenden Erfindung, eine Temperaturregelvorrichtung der eingangs genannten Art zur Verfügung zu stellen, bei der im Falle einer Heizungsanlage eine in der Wirkung verbesserte Wärmesenke oder im Falle der Kühlungsanlage eine in der Wirkung verbesserte Kältesenke für den Thermogenerator mittels Raumluft erreicht werden kann.

Diese Aufgabe wird mittels einer Temperaturregelvorrichtung der eingangs genannten Art im Falle der Heizungsanlage mit den kennzeichnenden Merkmalen des Anspruchs 1 und im Falle der Kühlungsanlage mit den kennzeichnenden Merkmalen des Anspruchs 7 gelöst.

Vorteilhafte Ausbildungsformen der erfindungsgemäßen Temperaturregelvorrichtung sind in den abhängigen Ansprüchen dargestellt.

Im Folgenden wird die Erfindung anhand einer Heizungsanlage dargestellt. Eine äquivalente Betrachtung gilt für Kühlanlagen, in denen der Temperaturgradient im Thermogenerator eine im Vergleich zur Heizungsanlage umgekehrte Richtung aufweist. Physikalisch gesehen fließt zwar immer nur Wärme und nicht Kälte. Zur Vereinfachung der Darstellung soll jedoch für den Fall einer Kühlanlage von einer Kältequelle gesprochen werden, von der aus für die angestrebte Kühlung Kälte weitergeleitet wird. Für die zu Heizungsanlagen äquivalente Betrachtung von Kühlanlagen ist an die Stelle der Wärmequelle eine Kältequelle, an die Stelle der Wärmesenke eine Kältesenke, an die Stelle des Kühlblocks ein Wärmeblock und an die Stelle des Kühlwandelements ein Wärmewandelement zu setzen.

Temperaturregelvorrichtungen weisen in der Regel ein zusammenhängendes oder aus mehreren Teilen bestehendes Gehäuse auf. Zumindest die Außenwand des Gehäuses weist in der Regel unmittelbaren Kontakt zur umgebenden Atmosphäre auf.

Anders als im Stand der Technik umfasst die Gehäusewand der erfindungsgemäßen Temperaturregelvorrichtungen ein Kühlwandelement, das als Wärmesenke oder als Bestandteil der Wärmesenke für den Thermogenerator dient und zumindest einen Teil der Gehäuseaußenwand bildet. Auf diese Weise kann die Wärmesenke mit einer wirksamen Oberfläche ausgestattet werden, die im Vergleich zu einem lediglich im Gehäuse befindlichen Kühlblock groß ist. Außerdem sorgt im Allgemeinen die Konvektion an der Außenwand des Gehäuses für einen kontinuierlichen Austausch der kühlenden Atmosphäre, während die im Gehäuse befindliche Atmosphäre in der Regel in ihrer Bewegung und im Austausch und damit gleichzeitig auch die Wärmeabfuhr behindert wird.

Zudem brauchen am Gehäuse keine Lüftungsschlitze vorgesehen zu werden, was zum einen vorteilhaft für die Optik sein kann, zum anderen den Eintritt von Staub und Schmutz in das Innere des Gehäuses verhindert oder zumindest verringert.

Sofern notwendig kann ein Spannungsverstärker für die Thermogenerator-Spannung vorgesehen werden.

Vorteilhaft kann die Wärmesenke zusätzlich zum Kühlwandelement einen im Gehäuse oder am Gehäuse platzierten Kühlblock umfassen. Kühlwandelement und Kühlblock können einstückig oder aber im thermischen Kontakt stehende separate Einheiten sein, die gemeinsam die Wärmesenke bilden. Das mindestens eine Kühlwandelement und/oder der mindestens eine Kühlblock können/kann zumindest teilweise aus mindestens einem Metall oder mindestens einer Metalllegierung, vorzugsweise aus Aluminium, Kupfer und/oder Messing, bestehen.

Es kann vorteilhaft sein, das mindestens eine Kühlwandelement schalenförmig auszubilden, z. B. als Teilschale, vorzugsweise Halbschale, für das Gehäuse der Temperaturregelvorrichtung. Eine vollständige Frontwand ist Bestandteil des Kühlwandelements, wobei eine solche Frontwand eine Öffnung für einen Regelknopf der Temperaturregelvorrichtung aufweist.

Die Frontwand ist bevorzugt so angeordnet, dass sie bei montierter Temperaturregelvorrichtung von dem zu regelnden Heizkörper abgewandt ist. Das Kühlwandelement kann zusätzlich zur Frontwand auch Seitenwände oder Teile der Seitenwände des Gehäuses umfassen. Hierdurch kann die Kühlwirkung weiter verstärkt werden. Ein der Heizungsanlage zugewandter und nicht mehr zur erfindungsgemäßen Wärmesenke gehörender Teil des Gehäuses kann aus einem schlecht wärmeleitenden Material, z. B. aus einem Kunststoff, bestehen oder vom mindestens einen Kühlwandelement thermisch isoliert sein. Damit wird eine weitgehende thermische Entkopplung des mindestens einen Kühlwandelements und damit der Wärmesenke vom Heizungskörper erreicht.

Es hat es sich weiterhin als vorteilhaft herausgestellt, die Frontwand mit einer konvexen, d.h. nach außen gewölbten, Krümmung zu versehen. Hierdurch kann die Konvektionsströmung an der Gehäuseaußenwand begünstigt werden. Die konvexe Form kann ballig, z.B. sphärisch oder ellipsoidisch, sein. Als vorteilhaft hat sich eine konvexe Krümmung ergeben, bei der die Frontwand in einer ersten Richtung keine oder eine allenfalls minimale Krümmung und in einer zur ersten Richtung senkrechten Ebene eine Hauptkrümmung aufweist. Die Hauptkrümmung kann z.B. kreisförmig mit einem konstanten Radius, elliptisch oder mit variierendem Radius sein. Bei variierendem Radius ist die Variation bevorzugt stetig, d.h. ohne sprunghafte Radiusänderung. Empirisch hat sich für den Fall eines konstanten Krümmungsradius der Hauptkrümmung eine Radiuslänge von mindestens 75 mm und höchstens 200 mm als besonders vorteilhaft ergeben.

Vorteilhafte Ausbildungsformen der erfindungsgemäßen Temperaturregelvorrichtung werden im Folgenden anhand von Figuren dargestellt.

Es zeigt
- Fig.1:: in perspektivischer Ansicht ein Gehäuse für einen Thermostaten mit Regelknopf und Überwurfmutter für den Anschluss an einen Heizungszulauf,
- Fig. 2:: das Gehäuse gemäß Fig. 1 in seitlicher Ansicht ohne Regelknopf,
- Fig. 3:: eine teils perspektivisch, teils geschnittene Ansicht eines Teils des Gehäuseinneren mit Kühlblock, Thermogenerator und Wärmeleitungselement,
- Fig. 4:: eine Explosionsdarstellung des Gehäuses mit diversen weiteren Elementen und
- Fig. 5:: das Gehäuse in der Ansicht gemäß Fig. 3 mit weiterem inneren Aufbau.

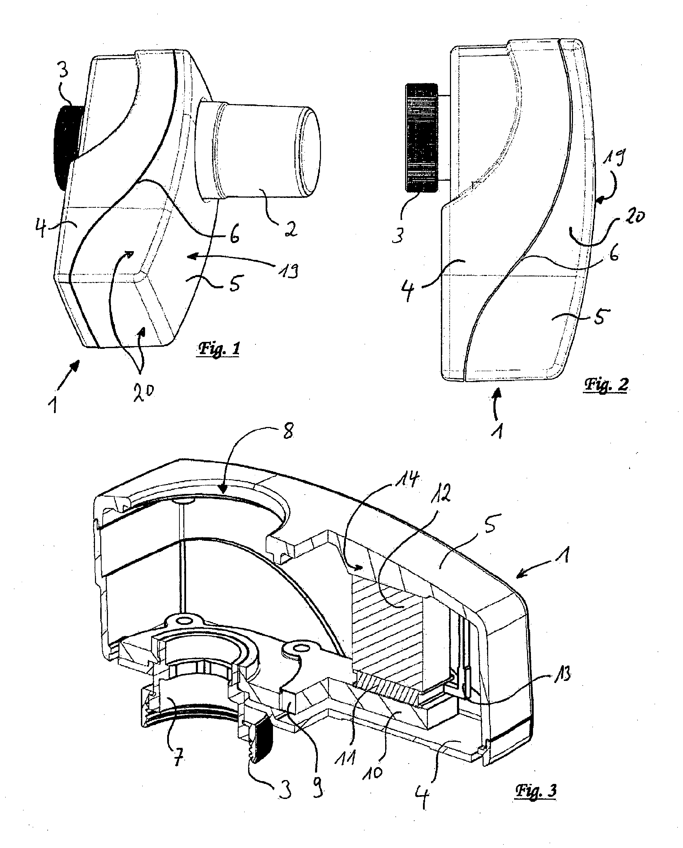

Fig. 1 zeigt perspektivisch das Äußere eines Thermostaten mit einem Gehäuse 1, einem an einer Frontwand 19 angeordneten Regelknopf 2 und einer Überwurfmutter 3 für den Anschluss an einen hier nicht dargestellten Heizkörper. Fig. 2 zeigt den gleichen Thermostaten wie Fig. 1, jedoch ohne Regelknopf 2. Das Gehäuse 1 umfasst eine dem Heizkörper zugewandte Kunststoff-Halbschale 4 sowie eine die Frontwand 19 und Seitenwände 20 aufweisende Aluminium-Halbschale 5, die entlang einer geschwungenen Linie 6 aneinander stoßen und einander begrenzen. Die Aluminium-Halbschale 5 und die Kunststoff-Halbschale 4 bilden eine mit der umgebenden Atmosphäre in Kontakt stehende Gehäuseaußenwand.

Fig. 3 zeigt perspektivisch einen Blick in das Innere des aufgeschnittenen Gehäuses 1, wobei der Schnitt sowohl durch die Aluminium-Halbschale 5 als auch durch die Kunststoff-Halbschale 4 geführt wurde. Durch den Schnitt ist jeweils nur zur Hälfte die Überwurfmutter 3, ein die Überwurfmutter 3 tragendes Anschlussstück 7 sowie eine Öffnung 8 für den Regelknopf 2 zu erkennen.

Ein Wärmeleitelement 9 hat unmittelbaren Kontakt zum Anschlussstück 7 und endet in der Figur nach rechts in einem Endstück 10, auf dem ein Thermogenerator 11 angeordnet ist. Ist der Thermostat an einem hier nicht dargestellten Heizkörper angeschlossen, wird durch die Wärme des dem Heizkörper zufließenden Heizungswassers das Anschlussstück 7 und durch den umlaufenden Kontakt zwischen Anschlussstück 7 und Wärmeleitelement 9 auch das Endstück 10 des Wärmeleitelements 9 erwärmt. Damit wirkt das Endstück 10 für den Thermogenerator 11 als Wärmequelle.

Dem Endstück 10 gegenüberliegend steht ein Kühlblock 12 aus Aluminium in Kontakt mit dem Thermogenerator 11. Der Kühlblock 12 wiederum steht im unmittelbaren thermischen Kontakt zu einem einstückig zur Aluminium-Halbschale 5 gehörenden Kühlblockpodest 14, so dass die Aluminium-Halbschale 5 und der Kühlblock 4 gemeinsam die Wärmesenke für den Thermogenerator bilden. Die gesamte Aluminium-Halbschale 5 mit ihrer Frontwand 19 und den Seitenwänden 20 (Fig. 1, 2 und 4) dient als Kühlwandelement im Sinne der Ansprüche.

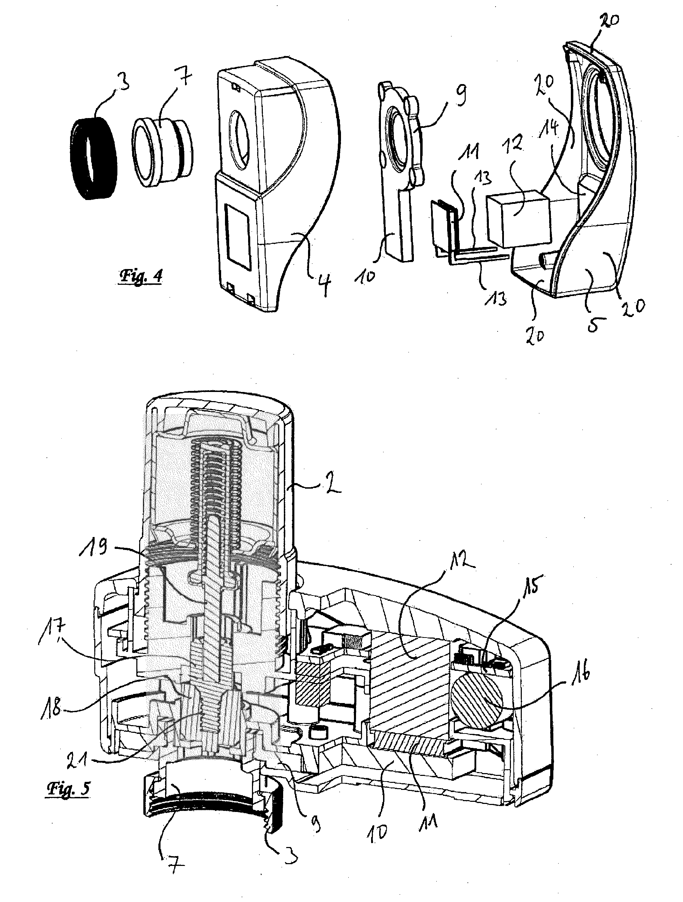

Aufgrund des durch Endstück 10 und Wärmesenke im Thermogenerator 11 erzeugten Temperaturgradienten wird im Thermogenerator 11 mittels des Seebeck-Effekts eine Thermospannung erzeugt, die über Abgreifleitungen 13 abgegriffen wird. Die abgegriffene Spannung kann unmittelbar oder über einen Spannungsverstärker zum Betrieb eines nicht dargestellten Motors und/oder zum Aufladen eines Akkumulators 16 (siehe Fig. 5) eingesetzt werden. Für das Aufladen des Akkumulators 16 oder zu anderen Zwecken kann zusätzlich mindestens ein weiterer Energieharvester, z.B. eine Solarzelleneinheit, vorgesehen werden.

Fig. 4 zeigt die bislang beschriebenen Elemente des Thermostaten in einer explosionsartigen Darstellung, nämlich die Aluminium-Halbschale 5, den Kühlblock 12, den Thermogenerator 11 mit seinen Abgreifleitungen 13, das Wärmeleitelement 9 mit seinem Endstück 10, die Kunststoff-Halbschale 4, das Anschlussstück 7 und die Überwurfmutter 3.

Die Aluminium-Halbschale 5 ist bei einem an einen Heizkörper angeschlossenen Thermostaten von dem Heizkörper abgewandt und wird durch die Konvektion der umgebenden Luft ständig von dieser umströmt. Die Aluminium-Halbschale 5 wird durch diese Strömung weitgehend auf Umgebungstemperatur gehalten. Durch den zur Aluminium-Halbschale 5 gehörenden und in der Frontwand 19 eingearbeiteten Kühlblockpodest 14 und den hierdurch gegebenen unmittelbaren Kontakt zum Kühlblock 12 wird letzterer mittelbar ebenfalls durch die an der Aluminium-Halbschale 5 vorbeiströmenden Umgebungsluft wirksam gekühlt, so dass ein hinreichender Temperaturgradient zwischen dem Endstück 10 des Wärmeleitelements 9 und dem Kühlblock 12 aufgebaut werden kann, welcher vom Thermogenerator 11 ausgenutzt wird.

Als besonders vorteilhaft hat sich die konvexe, d.h. nach außen gekrümmte Form der Frontwand 19 der Aluminium-Halbschale 5 ergeben, die insbesondere in Fig. 2 deutlich wird. Hierdurch wird die Luftströmung in besonders wirksamer Weise an der Aluminium-Halbschale 5 entlang geführt. Die Aluminium-Halbschale 5 bietet in der gegebenen Form zum einen eine große Oberfläche und zum anderen wenig Strömungswiderstand, so dass eine optimierte Wärmeaufnahme durch die vorbeiströmende Luft gewährleistet ist. In einer zur Zeichnungsebene senkrechten Richtung weist die Frontwand - hierbei sind die Randbereiche zu den Seitenwänden 20 ausgenommen - keine oder allenfalls eine sehr geringe Krümmung auf. Innerhalb der Zeichnungsebene hingegen beträgt der Krümmungsradius etwa 165 mm

Fig. 5 zeigt schließlich einen um weitere Elemente ergänzten Aufbau des Gehäuseinneren des Thermostaten in einem Schnitt entsprechend dem in Fig. 3. Der Thermogenerator 11 ist zwischen dem Endstück 10 des Wärmeleitelements 9 und dem Kühlblock 12 angeordnet. Mittels einer Platine 15 wird dem Thermostaten die notwendige Elektronik zur Verfügung gestellt. Unterhalb der Platine 15 befindet sich ein Lithium-Ionen-Ackumulator 16, der mittels der vom Thermogenerator 11 gelieferten Spannung aufgeladen werden kann. Über den Akkumulator 16 wird ein nicht dargestellter Motor betrieben, mit dem sich die Rotationsstellung einer Schnecke 17 verändern lässt. Die Schnecke 17 verstellt über ein Gewinde 21 die in der Zeichnung vertikale Position eines Koppelelements 18, welches wiederum die Stellung eines hier nicht dargestellten Ventils bestimmt, mit dem der Durchsatz von Heizungswasser in einem Heizungszulauf gesteuert wird. Die Schnecke 17 wirkt somit als Ventilführungselement. Mittels des Regelknopfes 2 wird über einen Stößel 19 eine Grundposition der Schnecke 17 vorgegeben.

### Bezugszeichenliste

- 1: Gehäuse
- 2: Regelknopf
- 3: Überwurfmutter
- 4: Kunststoff-Halbschale
- 5: Aluminium-Halbschale
- 6: geschwungene Linie
- 7: Anschlussstück
- 8: Öffnung für Regelknopf
- 9: Wärmeleitelement
- 10: Endstück
- 11: Thermogenerator
- 12: Kühlblock
- 13: Abgreifleitung
- 14: Kühlblockpodest
- 15: Platine
- 16: Akkumulator
- 17: Ventilführungselement
- 18: Koppelelement
- 19: Frontwand
- 20: Seitenwand
- 21: Gewinde

## Patentansprüche

1. Temperaturregelvorrichtung, nämlich Thermostatvorrichtung, für einen heizenden Wärmetauscher, umfassend
ein Gehäuse (1) mit einer für den Kontakt mit umgebender Atmosphäre vorgesehenen Gehäuseaußenwand (19, 20), ein Ventilführungselement (17), eine die Ventilführungselementstellung beeinflussende Motoreinheit und eine einen Thermogenerator (11) umfassende Energieversorgungseinrichtung für die Motoreinheit, wobei der Thermogenerator (11) einerseits eine Wärmequelle und andererseits eine Wärmesenke wärmeleitend kontaktiert,
**dadurch gekennzeichnet, dass**
die Wärmesenke mindestens ein Kühlwandelement umfasst, welches zumindest einen Teil der Gehäuseaußenwand (19, 20) bildet, wobei das mindestens eine Kühlwandelement die Frontwand (19) bildet, wobei die Frontwand (19) eine Öffnung (8) für einen Regelknopf (2) aufweist.

2. Temperaturregelvorrichtung nach Anspruch 1, **dadurch gekennzeichnet, dass** die Wärmesenke zusätzlich mindestens einen die Gehäuseaußenwand (19, 20) wärmeleitend kontaktierenden Kühlblock (12) umfasst.

3. Temperaturregelvorrichtung nach Anspruch 1 oder 2, **dadurch gekennzeichnet, dass** das mindestens eine Kühlwandelement und/oder der mindestens eine Kühlblock (12) zumindest zum Teil aus Metall und/oder einer Metalllegierung, vorzugsweise aus Aluminium, Messing und/oder Kupfer, bestehen/besteht.

4. Temperaturregelvorrichtung nach einem der vorhergehenden Ansprüche, **dadurch gekennzeichnet, dass** das mindestens eine Kühlwandelement schalenförmig ist.

5. Temperaturregelvorrichtung nach einem der vorherigen Ansprüche, **dadurch gekennzeichnet, dass** die Frontwand (19) zumindest eine zumindest in einer Richtung konvex (nach außen) gekrümmte Außenfläche aufweist, wobei der Krümmungsradius mindestens 75 mm und höchstens 200 mm beträgt.

6. Temperaturregelvorrichtung nach Anspruch 5, **dadurch gekennzeichnet, dass** das mindestens eine Kühlwandelement mindestens eine sich im Wesentlichen senkrecht von der Frontwand (19) erstreckende Seitenwand (20) aufweist.

7. Temperaturregelvorrichtung, nämlich Thermostatvorrichtung, für einen kühlenden Wärmetauscher, umfassend
ein Gehäuse (1) mit einer für den Kontakt mit umgebender Atmosphäre vorgesehenen Gehäuseaußenwand (19, 20), ein Ventilführungselement (17), eine die Ventilführungselementstellung beeinflussende Motoreinheit und eine einen Thermogenerator (11) umfassende Energieversorgungseinrichtung für die Motoreinheit, wobei der Thermogenerator (11) unmittelbar oder mittelbar einerseits einer Kältequelle und andererseits eine Kältesenke wärmeleitend kontaktiert,
**dadurch gekennzeichnet, dass**
die Kältesenke mindestens ein zumindest einen Teil der Gehäuseaußenwand (19, 20) bildendes Wärmewandelement umfasst, wobei das mindestens eine Wärmewandelement die Frontwand (19) bildet, wobei die Frontwand (19) eine Öffnung (8) für einen Regelknopf (2) aufweist.

8. Temperaturregelvorrichtung nach Anspruch 7, **gekennzeichnet durch** die Gesamtheit der Merkmale eines der Ansprüche 2 bis 6 mit der Maßgabe, dass
a) das Wort Wärmesenke jeweils durch das Wort Kältesenke,
b) das Wort Kühlblock jeweils durch das Wort Wärmeblock und
c) das Wort Kühlwandelement jeweils durch das Wort Wärmewandelement ersetzt wird.

## Claims

1. Temperature control device, namely a thermostat device, for a heating heat exchanger, comprising a housing (1) with a housing outer wall (19, 20) provided for contact with the surrounding atmosphere, a valve guide element (17), a motor unit influencing the valve guide element position, and an energy supply means, comprising a thermoelectric generator (11), for the motor unit, wherein the thermoelectric generator (11) makes contact in a heat-conducting manner firstly with a heat source and secondly with a heat sink,
**characterized in that**
the heat sink comprises at least one cooling wall element which forms at least a part of the housing outer wall (19, 20), wherein the at least one cooling wall element forms the front wall (19), wherein the front wall (19) has an opening (8) for a control knob (2) .

2. Temperature control device according to Claim 1, **characterized in that** the heat sink additionally comprises at least one cooling block (12) making contact in a heat-conducting manner with the housing outer wall (19, 20).

3. Temperature control device according to Claim 1 or 2, **characterized in that** the at least one cooling wall element and/or the at least one cooling block (12) are/is composed at least partially of metal and/or a metal alloy, preferably of aluminium, brass and/or copper.

4. Temperature control device according to one of the preceding claims, **characterized in that** the at least one cooling wall element is shell-shaped.

5. Temperature control device according to one of the preceding claims, **characterized in that** the front wall (19) has at least one outer surface which is curved convexly (outwards) at least in one direction, wherein the radius of curvature is at least 75 mm and at most 200 mm.

6. Temperature control device according to Claim 5, **characterized in that** the at least one cooling wall element has at least one side wall (20) extending substantially perpendicularly from the front wall (19).

7. Temperature control device, namely a thermostat device, for a cooling heat exchanger, comprising a housing (1) with a housing outer wall (19, 20) provided for contact with the surrounding atmosphere, a valve guide element (17), a motor unit influencing the valve guide element position, and an energy supply means, comprising a thermoelectric generator (11), for the motor unit, wherein the thermoelectric generator (11) makes contact in a heat-conducting manner directly or indirectly firstly with a cold source and secondly with a cold sink,
**characterized in that**
the cold sink comprises at least one heating wall element forming at least a part of the housing outer wall (19, 20), wherein the at least one heating wall element forms the front wall (19), wherein the front wall (19) has an opening (8) for a control knob (2).

8. Temperature control device according to Claim 7, **characterized by** the entirety of the features of one of Claims 2 to 6, with the proviso that
a) the words heat sink are replaced in each case by the words cold sink,
b) the words cooling block are replaced in each case by the words heating block, and
c) the words cooling wall element are replaced in each case by the words heating wall element.

## Revendications

1. Dispositif de régulation de la température, à savoir un dispositif thermostatique, pour un échangeur de chaleur à chauffer, comprenant un boîtier (1) avec une paroi extérieure de boîtier (19, 20) prévue pour le contact avec l'atmosphère environnante, un élément de guidage de soupape (17), une unité de moteur influençant la position de l'élément de guidage de soupape et un dispositif d'alimentation en énergie comprenant un thermogénérateur (11) pour l'unité de moteur, dans lequel le thermogénérateur (11) est en contact de conduction thermique d'une part avec une source de chaleur et d'autre part avec un puits de chaleur, **caractérisé en ce que** le puits de chaleur comprend au moins un élément de paroi de refroidissement, qui forme au moins une partie de la paroi extérieure de boîtier (19, 20), dans lequel ledit au moins un élément de paroi de refroidissement forme la paroi avant (19), dans lequel la paroi avant (19) présente une ouverture (8) pour un bouton de réglage (2) .

2. Dispositif de régulation de la température selon la revendication 1, **caractérisé en ce que** le puits de chaleur comprend en outre au moins un bloc de refroidissement (12) en contact de conduction thermique avec la paroi extérieure de boîtier (19, 20).

3. Dispositif de régulation de la température selon la revendication 1 ou 2, **caractérisé en ce que** ledit au moins un élément de paroi de refroidissement et/ou ledit au moins un bloc de refroidissement (12) se compose(nt) au moins en partie de métal et/ou d'un alliage métallique, de préférence d'aluminium, de laiton et/ou de cuivre.

4. Dispositif de régulation de la température selon l'une quelconque des revendications précédentes, **caractérisé en ce que** ledit au moins un élément de paroi de refroidissement est en forme de coquille.

5. Dispositif de régulation de la température selon l'une quelconque des revendications précédentes, **caractérisé en ce que** la paroi avant (19) présente au moins une surface extérieure incurvée de façon convexe (vers l'extérieur) dans au moins une direction, dans lequel le rayon de courbure vaut au moins 75 mm et au plus 200 mm.

6. Dispositif de régulation de la température selon la revendication 5, **caractérisé en ce que** ledit au moins un élément de paroi de refroidissement présente une paroi latérale (20) s'étendant essentiellement perpendiculairement à partir de la paroi avant (19).

7. Dispositif de régulation de la température, à savoir un dispositif thermostatique, pour un échangeur de chaleur à refroidir, comprenant un boîtier (1) avec une paroi extérieure de boîtier (19, 20) prévue pour le contact avec l'atmosphère environnante, un élément de guidage de soupape (17), une unité de moteur influençant la position de l'élément de guidage de soupape et un dispositif d'alimentation en énergie comprenant un thermogénérateur (11) pour l'unité de moteur, dans lequel le thermogénérateur (11) est en contact de conduction thermique directement ou indirectement d'une part avec une source de froid et d'autre part avec un puits de froid, **caractérisé en ce que** le puits de froid comprend au moins un élément de paroi de chauffage, qui forme au moins une partie de la paroi extérieure de boîtier (19, 20), dans lequel ledit au moins un élément de paroi de chauffage forme la paroi avant (19), dans lequel la paroi avant (19) présente une ouverture (8) pour un bouton de réglage (2) .

8. Dispositif de régulation de la température selon la revendication 7, **caractérisé par** la totalité des caractéristiques d'une des revendications 2 à 6, avec la condition que l'on remplace chaque fois
a) le mot puits de chaleur par le mot puits de froid,
b) le mot bloc de refroidissement par le mot bloc de chauffage, et
c) le mot élément de paroi de refroidissement par le mot élément de paroi de chauffage.
